Europäisches Patentamt

European Patent Office

Office européen des brevets

(11) Publication number: **0 513 639 A2**

# EUROPEAN PATENT APPLICATION

(21) Application number: **92107591.7**

(22) Date of filing: **06.05.92**

(51) Int. Cl.⁵: **H01L 29/60**, H01L 21/28, H01L 21/76, H01L 21/82

(30) Priority: **16.05.91 US 701248**

(43) Date of publication of application: **19.11.92 Bulletin 92/47**

(84) Designated Contracting States: **DE FR GB**

(71) Applicant: **International Business Machines Corporation**
**Old Orchard Road**
**Armonk, N.Y. 10504(US)**

(72) Inventor: **Hohn, Fritz Juergen**
**146 Mittchel Road**
**Somers, New York 10598(US)**
Inventor: **Reeves, Clive Malcom**
**854 Constant Avenue**
**Peekskill, New York 10566(US)**

(74) Representative: **Klocke, Peter, Dipl.-Ing.**
**IBM Deutschland GmbH Patentwesen und Urheberrecht Schönaicher Strasse 220**
**W-7030 Böblingen(DE)**

(54) **Semiconductor field effect transistor device and fabrication thereof.**

(57) A semiconductor device comprising a semiconductor substrate (1) having therein channel regions; a gate dielectric layer (2) over the channel region; gate electrodes (3) over the gate dielectric layer; doped regions (4, 5) self-aligned with respect to the gate electrodes (3); isolation trenches (6) containing isolating material (7); isolation material (8) on the sides of the gate electrodes which are self-aligned in the width direct such that the gates (3) butt against the trenches (6) without overlap; an insulation layer (13) through which contact windows are etched; and finally metallic-type high conductivity electrical interconnects (14) to the gate electrodes (3) and the source and drain regions (4, 5); are provided. Also, a method for fabricating such devices is provided.

*FIG. 8*

The present invention is concerned with semiconductor field effect transistor devices and a method for fabricating the devices, and is especially concerned with devices wherein the gate is self-aligned and butted against the trench isolation. The present invention is particularly advantageous in obtaining ultra-compact and high performance devices.

The field effect transistor (FET) is an important electrical switching device in large scale integrated circuits. Such circuits may contain as many as one million or more FETs on a single semiconductor chip. Such chips typically measure, today, approximately one-half of one inch on each side. The physical size (i.e., the lateral dimensions) of the FET is an important factor in determining how closely, devices may be packed into a given chip area. In addition, the speed of operation of a circuit is determined in part by the size of the individual FET elements, especially the length of the gate electrode. Accordingly, continuing work is being carried out to provide new procedures which will yield smaller and faster FET structures. For instance, the structure of nearly-fully-scaled 0.1 micron NMOS devices has been proposed and demonstrated, see SAI-HALASZ et. al., "Design and Experimental Technology for 0.1 - $\mu$m Gate-Length Low Temperature operation FET's," IEEE Electron Device Letters, Volume EDL-8, 10, 1987, page 463. These devices are not fully-scaled in that 0.1 micron lithography is used for the gate level only, with all other device levels (such as isolation, contacts and interconnects) using 0.25 micron lithography. Consequently, no significant improvement in packing density is achieved beyond what would be expected for fully-scaled 0.25 micron FET technology. Therefore, it is desirable that such types of devices be fabricated employing 0.1 micron lithography at all device levels.

It should be kept in mind that all lithographic exposure systems have a finite misregistration due to the inherent physical limitations that naturally occur in an electromechanical system. This combined with substrate distortions arising from hot processing give rise to a finite misregistration of each device level with respect to previous levels. Such misregistration must be accommodated within the design of the device. For 0.1 micron lithography a maximum allowable misregistration of ±0.025 microns can be expected.

Object of the present invention as claimed is to provide a technique capable of fabricating ultra-compact FET devices whereby the gate electrode is self-aligned and butted against the trench isolation. The present invention provides for achieving contacts which fully overlap the gate at the same time as providing contacts which overlap fully the source and drain regions. These techniques are of particular advantage for 0.1 micron FET technology but can be applied with certain advantage at larger or possibly smaller dimensions.

In particular, the present invention is concerned with a semiconductor device that comprises a semiconductor substrate having therein channel regions that contain active impurities of a first conductive type. Located over the channel regions is a dielectric layer and over the dielectric layer are patterned gate electrodes. Doped source and drain regions of a second and opposite conductivity type are self-aligned with respect to the ends of the gate electrode in the length direction. Isolation trenches containing isolating material are provided as well as isolation to the sidewalls of the gate electrodes. The gate electrodes are self-aligned in the width direction to the isolation trenches such that the gates are butted against the isolation trenches without overlap. An insulating layer is present over the entire substrate except where contact windows to the gate electrodes and source and drain regions are provided. Metallic-type high conductivity electrical interconnection tracks are also provided which contact through the contact windows to the gate electrodes and source and drain regions.

The process aspect of the present invention is concerned with a method for fabricating a semiconductor device which comprises the following steps:

(a) Providing a semiconductor substrate;

(b) Providing a gate dielectric layer on said substrate;

(c) Providing in said substrate active impurities of a first conductive type for forming channel regions;

(d) Providing and delineating gate electrodes above said gate dielectric layer;

(e) Providing in said substrate active impurities of a second and opposite conductivity type for forming source and drain regions that are self-aligned to said gate electrodes;

(f) Etching isolation trenches in preselected regions of said substrate in a manner such that the gate electrode is removed wherever it overlaps the trench;

(g) Providing isolating materials in said isolation trenches and on the sides of said gate electrodes;

(h) Providing insulating material over said substrate and said gate electrodes;

(i) Delineating contact windows to said gate electrodes and said source and drain regions;

(j) Providing and delineating a metallic-type high conductivity electrical interconnection pattern that makes electrical connection to said gate electrodes and said source and drain regions.

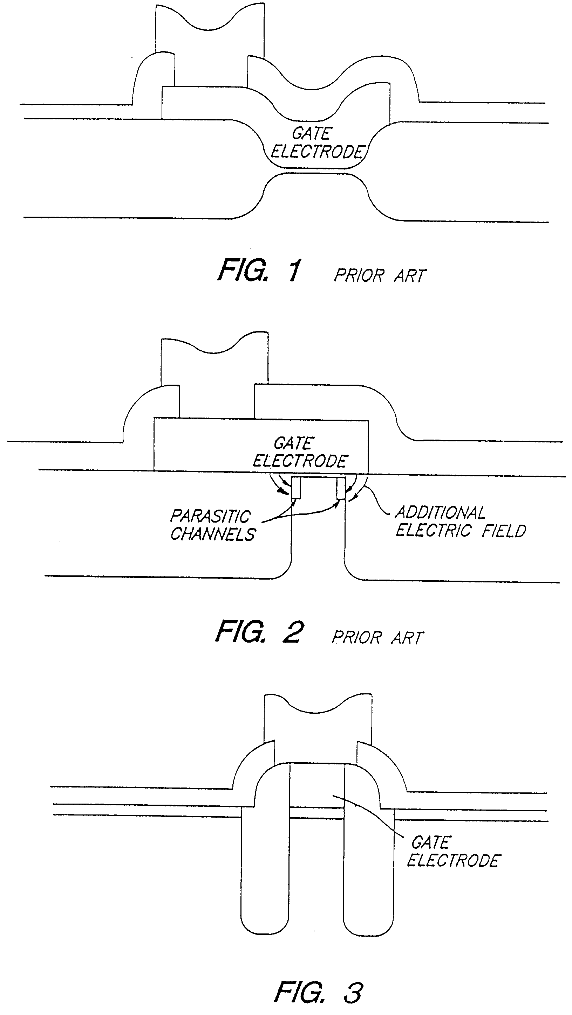

An advantage of the present invention is that it overcomes the problems inherent to conventional isolation techniques which occur as the device width approaches 0.1 micron dimensions. The technique of local oxidation of silicon (LOCOS) gives rise to a well-known "bird's beak" profile around the perimeter of the device (see Figure 1), which due to charge sharing effects leads to a well-known but undesirable variation in threshold voltage as the device width is reduced. Conventional trench isolation techniques solve this problem by providing an abrupt interface between device and isolation but are susceptible to parasitic FET operation at the abrupt corners of the device where the threshold voltage is effectively lowered due to increased electric field strength associated with the gate-to-trench overlap (see Figure 2). The present invention uses a similar approach to conventional trench isolation, in that it avoids formation of a "bird's beak," but differs in that there is no overlap between the gate and the trench thereby avoiding parasitic FET operation (see Figure 3).

The feature of butting the gate electrode against the trench isolation without overlap necessitates that gate contacts are made directly to the active gate electrode. Whilst the concept of a direct metallic-type contact to the active gate electrode is known to the art, the structure and suitable mode of fabrication of such contacts are unique to the present invention. Such direct gate contacts provide further advantage for ultra-small FETs in that a gate electrode RC time constant associated with current flow along the gate, in the width direction of the device, is eliminated and, additionally, the area required for a gate contact pad is eliminated which leads to improved packing density.

A further advantage of the present invention over conventional trench isolated devices is that the well-known difficulties associated with substrate planarization which normally follow deposition of the trench insulation material can be eliminated. Such planarization is usually required prior to deposition and delineation of the gate electrodes since they are required to traverse onto the trench isolation where a gate contact pad is provided for connection to the interconnect metalization.

For a better understanding of the present invention, together with further objects and advantages, a preferred embodiment and method of the invention are described in the following with reference to the accompanying drawings, in which:

Figure 1 is a schematic diagram of prior art LOCOS isolation showing "bird's beak."

Figure 2 is a schematic diagram of prior art trench isolation showing parasitic channels.

Figure 3 is a schematic diagram illustrating gate electrode butted-up to isolation trench as obtained by the present invention.

Figures 4-8 are cross-sectional views of a substrate in various stages of fabrication demonstrating the basic process of the present invention. Figure 9 is a plan view of a device pursuant to the present invention. Figure 10 is a schematic diagram of the gate-contact window illustrating a best case registration of the gate-contact window. Figure 11 is a schematic of the gate-contact window illustrating a worst case registration of the gate-contact window.

For convenience, the discussion of the fabrication steps is directed to the aspects of using a P-type silicon substrate as the semiconductor substrate and N-type impurities in the source and drain regions leading to N-channel FET technology. Accordingly, it is understood that an N-type substrate and P-type impurities in the source and drain regions could be employed pursuant to the present invention leading to P-channel FET technology.

Furthermore, it is understood that a combination of both N-channel and P-channel devices, pursuant to the present invention, could be combined onto a N-well, P-well or twin-well substrate using well-established techniques as described in the prior art, to obtain Complementary FET technology. For an example of complementary FET technology, applied at 0.25 micron ground rules, see Davari et al., "A High Performance 0.25$\mu$m CMOS Technology," IEDM Technical Digest, December 1988, page 56. It is also understood that when the discussion refers to N-type impurities the process steps are applicable to P-type impurities and vice versa. Also, the present invention is applicable to substrates other than silicon and to gate structures other than polycrystalline silicon. Moreover, the terms "polysilicon" and "polycrystalline silicon" are used here interchangeably as in the prior art. In addition, as used herein, the terms "metallic-type interconnection" or "high electrical conductivity interconnection" refer to tracks or lines of a metal, such as aluminum or tungsten, as well as to nonmetallic materials such as highly doped polysilicon or intermetallic silicides which nevertheless can have conductivities of the magnitude generally possessed by metals.

Also, when reference is made to impurities of a "first type" and impurities of a "second type," it is understood that the "first type" refers to N or P-type impurities and "second type" refers to the opposite conductivity type. That is, if the "first type" is P, then the "second type" is N. If the "first type" is N, then the "second type" is P. As used herein, the terms "gate" and "gate electrode" are interchangeable.

Furthermore, when reference is made to the "length direction" of the device, it is understood to refer to the direction from the source region to the drain region or visa versa. Similarly, the "width direction" is understood to be that direction which is orthogonal to the "length direction" and in the plane of the initial substrate interface.

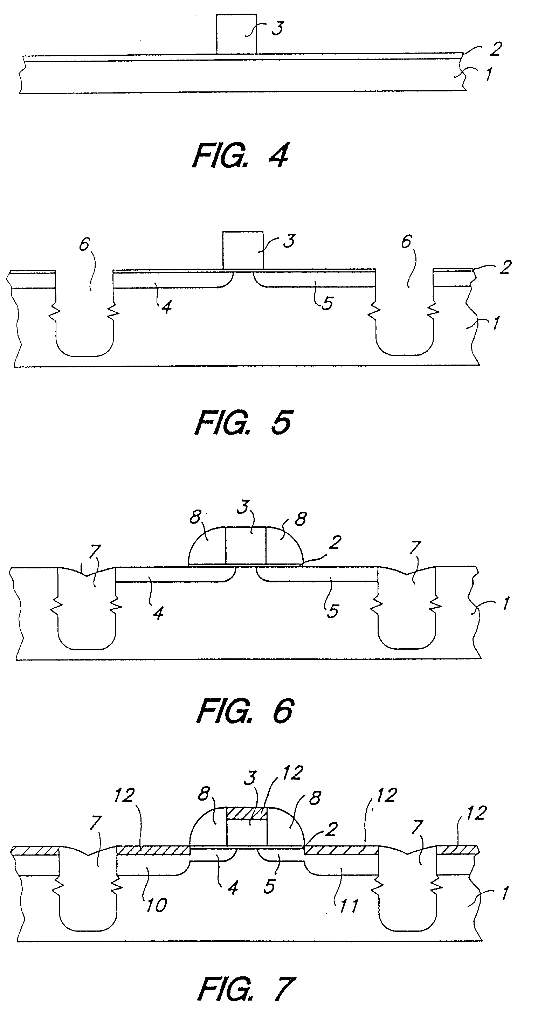

Referring to Figure 4, there is shown a fragment of a semiconductor substrate 1 which can typically be a silicon substrate having any desired crystal orientation but more normally (<100>) orientation. A gate dielectric layer 2 is provided on the substrate 1, typically an ultrathin silicon dioxide layer of about 2.5 to about 5 nanometers. Such can be formed by thermal oxidation of the silicon substrate for example at about 800° C in the presence of dry oxygen.

The desired channel impurity profiles, as required to establish suitable threshold voltages and to suppress punchthrough are provided by ion implantation, either before or after formation of the ultra-thin dielectric layer. In the case of P-type dopant for the channel region of the device, boron, aluminum, gallium, or indium could be used. Typically a boron implant of about $1 \times 10^{12}$ to $5 \times 10^{12}$ atoms/cm$^2$ at an energy of about 15 to about 30 keV is required for a device with a 0.1 micron gate electrode.

Next, the gate material 3 is deposited and patterned. For example a layer of polycrystalline silicon is deposited. The polysilicon layer is typically about 100 to 150 nanometers thick, and may be deposited by low pressure chemical-vapor deposition. The polysilicon layer is typically doped with an N-type dopant such as arsenic or phosphorus using ion implantation. The polysilicon is patterned using lithographic and etching techniques. In view of the process of the present invention, the polysilicon can be patterned with ultrasmall gate structures with dimensions as small as 0.1 microns or less. In order to pattern the gate material, a gate pattern determining layer such as a layer of photoresist material of the type employed in known lithographic masking and etching techniques can be placed over the polysilicon gate material. Any of the well-known photosensitive resist materials known to the art may be used. Application of the photoresist and appropriate lithographic procedures are well-known and described in the prior art. Such procedures are likely to be based on Gaussian or shaped electron beam lithography, X-ray printing, phase-shift optical printing or any other technique capable of resolving 0.1 micron images.

Patterning of the gate electrodes into the polysilicon layer can be performed by well-known dry etching techniques such as reactive ion etching or electron-cyclotron resonance etching. Such techniques employ conditions that selectively and anisotropically etch the polysilicon without etching the underlying gate dielectric layer. Also, a wide variety of process gases and etch conditions are suitable, but typically a process with chlorine, bromine or fluorine containing gases is used. This results in delineation of the polysilicon gate 3 as illustrated in figure 4. After the gate is defined, the photoresist material above the patterned gate is then removed, typically by oxygen plasma ashing.

Next, the source and drain regions are formed, self-aligned to the gate structures 3, by thermal diffusion or ion implantation into the substrate or well region in the case of complementary FET technology. In the case of N-type impurities for silicon, arsenic, phosphorus, or antimony can be employed. For P-type impurities for silicon, boron, aluminum, gallium, or indium can be employed. The source and drain regions are preferably ion implanted to provide ultra shallow junction profiles such as to a depth of about 50 to about 75 nanometers. For instance, an ultra shallow N-type region can be formed by an antimony implant of about $1 \times 10^{14}$ to about $5 \times 10^{14}$ atoms/cm$^2$ at an energy typically in the range of about 5 to about 25 keV. The source 4 and drain 5 regions are illustrated in figure 5.

Next, isolation trenches are formed to provide electrical isolation between devices. These are formed by lithographically masking the active areas of the devices and then etching trenches 6 into the substrate (see Figure 6). The trench images are defined into a photoresist layer, aligned with respect to the gate level to within a given misregistration tolerance. The resist image can be used directly as etch mask during the trench etching procedure; however, there are certain advantages in using an intermediate pattern transfer mask of, for example, silicon nitride. Such a mask provides superior etch masking properties compared to photoresist since mask erosion and faceting effects are reduced and, in addition, it can be used as an oxidation mask for a selective trench sidewall oxidation as discussed later. Such a mask can be formed by low pressure chemical vapor deposition of silicon nitride prior to application of the photoresist. After patterning the photoresist, the transfer mask would be formed by reactive ion etching in a well-known methyl-trifluoride process. Next, the isolation trenches 6 are etched using the nitride pattern transfer layer as a mask. This is achieved using a multiple step reactive ion etching process whereby the process first cuts through the gate electrodes where they overlap the trench regions. This is an essential feature of the device process in that it provides self-alignment of the gate electrode, in the width direction, so that it butts against the isolation trench without overlap. The trench reactive ion etching process is required to etch polysilicon, gate dielectric and substrate silicon and a bromine or chlorine based process can be used. If the process exhibits high etch selectivity with respect to the gate dielectric then it is necessary to interrupt the trench etching process after the gate polysilicon gate electrode has been etched, in order to etch the underlying gate dielectric using a short methyl-trifluoride etch, after which the trench etch can be continued to completion.

The resulting trenches have substantially vertical surfaces in the silicon substrate 1. The trenches are likely to be of fixed width although variable width trenches could be employed. In the case of fixed width trenches, the trench width is likely to be about 0.1 to 0.15 microns and the depth in the range 0.25 to 0.5 microns.

Next, a passivating layer, such as silicon dioxide, is grown on at least the vertical sidewalls of the trench. In particular, if nitride is used as an intermediate trench etch mask, it provides protection for the horizontal surfaces of the device during this oxidation step.

The thickness of such an oxide passivation is likely to be about 10 nanometers, preferably formed by dry oxidation at about 700 to 750°C. A relatively low oxidation temperature is chosen to avoid significant redistribution of the source and drain region impurities. The silicon nitride, if present, is then stripped using a phosphoric acid wet etching step.

The trenches are filled with insulating material 7 using a well-known conformal deposition technique such as low pressure chemical vapor deposition in a tetra-ethoxy-silane ambient. In addition, oxide will form over the entire substrate and the gate structures. The insulating layer is then etched back, using an anisotropic oxide reactive ion etching process, to leave the trenches filled with insulating material and insulating layers 8 on the sidewalls of the gates (Fig. 6). The thickness of the sidewall is likely to be approximately 0.1 microns. This insulating material on the sidewalls of the gate acts to compensate for possible misalignment of masks when producing contact windows in the subsequent steps to provide for metallic-type interconnection to the gate electrode.

According to preferred aspects of the present invention, a second source 10 and drain 11 can be provided by thermal diffusion or preferably by ion implantation to a depth of about 100 nanometers. Such is not necessary but preferred in order to improve the structure by lowering the resistance between the contacts and channel region and thereby increasing the performance of the device. Typically such can be provided by ion implantation of arsenic with a dose of about $5 \times 10^{15}$ atom/cm$^2$ at an energy of approximately 25 keV.

Also, according to the preferred but not necessary aspects of the present invention, as shown in Fig. 7 a self-aligned silicidation of the gate, source and drain regions can be carried out to provide silicide layer 12. Such is not essential but could be used to reduce the contact resistance between the subsequently to be applied metallic-type interconnection to the gate electrode and the source and drain. The silicidation can be performed by well known techniques based upon metal deposition, reaction at elevated temperature and selective wet etching of non-reacted metal. The process is self-aligned in that silicide does not form over the trench isolation and gate sidewalls. See Figure 7. Metals such as titanium, tungsten, tantalum, platinum or cobalt may be used but more typically titanium is used. Typically, a silicide thickness, after reaction, of approximately 10 to 15 nanometers would be used.

In the case of the titanium silicide, this could be formed by first sputter depositing a layer of titanium which is rapid thermal annealed to form silicide at the silicon source and drain regions and also over the polysilicon gate electrodes. Typically, this might be a 30 second anneal at 600°C in a nitrogen ambient. Next, a selective wet etch, such as a solution of hydrogen peroxide and sulfuric acid, is used to remove the unreacted titanium leaving only the required titanium silicide. Finally, the silicidation process is completed with a second rapid thermal annealing step which serves to reduce the sheet resistivity of the silicide regions. Typical conditions for this second anneal are 60 seconds at 800°C again in the presence of nitrogen.

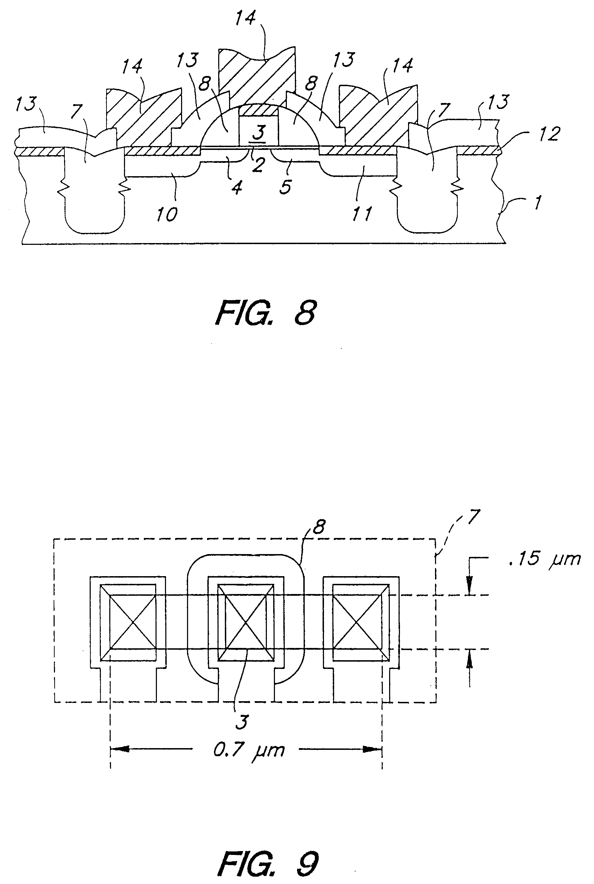

Next, an insulating layer 13 is deposited to provide isolation from the subsequently to be deposited metallic-type interconnects (Fig. 8). The material used for this layer is preferably one which has different reactive ion etching properties to insulating materials 7 and 8. For instance, if insulating materials 7 and 8 are silicon dioxide, then insulating material 13 can be silicon nitride. The silicon nitride can be provided by chemical vapor deposition using one of several well known processes. Typically, such a layer is about 0.1 to 0.2 microns thick.

Contact windows to the gate electrodes and source and drain regions are delineated, again using lithographic techniques to define a photoresist image which is used as a reactive ion etch mask. The contact windows are defined such that they are designed with a finite overlap to the gate sidewalls (in the case of the gate contact) and the trench isolation (in the case of the source and drain contacts). This finite overlap is designed to be equal to the maximum allowed level to level misregistration and is likely to be ±0.025 microns for 0.1 micron lithography. This ensures that the gate, source and drain contact windows overlap the maximum available area of the regions to be contacted by the subsequently to be deposited metallic type interconnection. This is of particular importance for ultra-small devices as pursuant to the present invention since specific contact resistance is potentially a significant device parasitic.

Preferably, layer 13 is etched under conditions which provide selectivity with respect to the material of 7 and 8 so that the necessary contact windows to the gate, source and drain regions can be defined to overlap such material without risk of etching into the gate sidewalls, in the case of the gate contact, or the isolation trenches in the case of the source and drain contacts. As described above, this overlap provides compensation for misregistration between the contact lithography level and previous levels and is chosen to be equal to the maximum misregistration. Such an approach leads to gate, source and drain contacts which overlap fully the respective regions to be contacted. Whilst such approaches are known in the art for source and drain regions only, the present invention makes use of the gate sidewalls 8 to extend the technique to include gate contacts.

Alternatively, if it is desired to employ the same material in layer 13 as for isolation 7 and 8, then a thin layer beneath 13 of a different material such as aluminum oxide, as known in the art, can be provided as an etch stop. The aluminum oxide would protect the isolation in the trenches and on the sidewalls of the gate since etching would stop once the thin layer was reached. The aluminum oxide would then be removed by known wet etching techniques without effecting the materials 7 and 8.

Next, the metallic-type high conductivity electrical interconnection 14 to the gate structure and, source and drain regions is formed. An example of a highly-conductive material commonly used for such interconnections is aluminum which may contain relatively small amounts of impurities to reduce electromigration effects or reduce chemical reactions between the aluminum and the semiconductor to be contacted. Alternatively, and more likely, the interconnect material will be a refractory metal such as tungsten or possibly a stack of materials with a refractory metal closest to the semiconducting material. Such refractory materials provide superior contact reliability which is of particular importance to the present invention in that direct contact is made to the gate electrode. Such interconnect materials can be deposited by sputtering, chemical vapor deposition or by evaporation. Once deposited, the interconnect patterns are delineated using a patterned photoresist image as mask for a reactive ion etching step designed to etch the unmasked interconnect material. See Figure 8.

As known in the art, further interconnection and insulation layers (not shown) and further devices (not shown) may be provided over the above described structure.

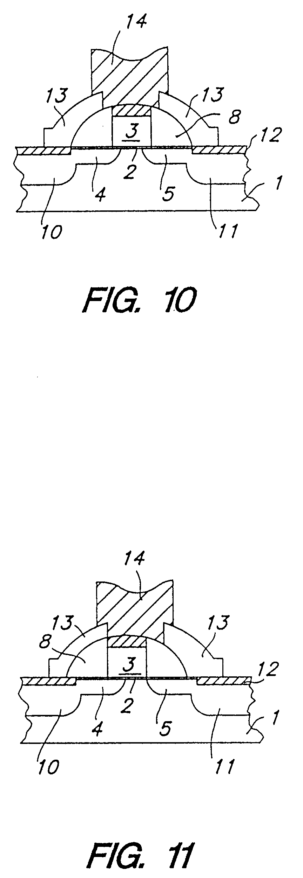

Reference to figure 9 illustrates a plan view of a field effect transistor pursuant to the present invention demonstrating the ultra small dimensions which may be achieved. Like numerals represent the same features as discussed above in figures 4 and 8. For instance, assuming the above desire for a fully scaled 0.1 micron device, the device has an active area with dimensions of 0.7 x 0.15 microns, separated from adjacent devices by a 0.15 micron wide isolation trench. At these dimensions, the device requires misregistrations to be less than or equal to ±0.025 microns for consecutive lithographic levels.

Figures 10 and 11 illustrate the gate contact region of the device in cross-section, clarifying the approach used in the present invention to achieve fully overlapped gate contacts which are capable of accommodating misregistration. Figure 10 shows perfect registration between the gate contact and the gate electrode. Figure 11 shows the maximum misregistration which can be tolerated whilst still maintaining full overlap of the gate electrode.

**Claims**

1. A method for fabricating a semiconductor device which comprises:

    (a) providing a semiconductor substrate (1);

    (b) providing a dielectric gate layer (2) on said substrate;

    (c) then providing in said substrate the active impurities of a first conductive type for channel regions;

    (d) then providing and delineating gate electrodes (3) above said dielectric layer (2);

    (e) then providing in said substrate active impurities of a second and opposite conductivity type for forming source (4) and drain (5) regions self-aligned to said gate electrodes (3);

    (f) then etching isolation trenches (6) in preselected regions of said substrate in such a way that the gate (3) is self-registered to butt against the trench (6) without overlap;

    (g) then providing isolation materials (7, 8) in said isolation trenches and on sidewalls of said gate electrodes;

    (h) providing insulating material (13) over said substrate and said gate electrodes;

    (i) delineating contact windows to said gate electrodes (3) and to said source (4) and drain (5) regions;

    (j) providing and delineating a metallic-type high conductivity electrical interconnection pattern (14) that makes electrical contact to said gate electrodes (3) and to said source (4) and drain (5) regions.

2. The method of claim 1 where prior to providing the isolation materials (7) in said isolation trenches (6), the sidewalls of said isolation trenches are passivated.

3. The method of claim 2 wherein sidewalls are passivated by thermal oxidation to provide silicon dioxide.

4. The method of claim 1, 2 or 3 wherein said isolation material (7, 8) in said trenches (6) and on the side-walls of said gate electrodes (3) is provided by conformal deposition of the insulating material followed by etching back of the layer.

5. The method of any one of the preceding claims which further includes a second source (10) and drain (11) formation step, subsequent to providing the isolation materials (7) in the isolation trenches (6) and on the sidewalls of the gate electrodes (3).

6. The method of any one of the preceding claims which further includes the formation of silicide layers (12) on said gate electrodes (3) and source (4) and drain (5) regions.

7. The method of any one of the preceding claims wherein the insulating material (13) for vertical isolation exhibits different etching characteristics to the insulating material (7, 8) in said isolation trenches and on the side-walls of said gate electrodes.

8. The method of any one of the preceding claims wherein the gate contact window is designed to overlap the insulating material (8) on the side-walls of the said gate electrodes (3) by a distance either equal to, or greater than, the maximum permitted lithographic misregistration of the contact windows with respect to the gate electrodes.

9. The method of any one of the preceding claims wherein said insulating material (7, 8) in said isolation trenches and on the sidewalls of said gate electrodes is silicon dioxide and the said material (13) of vertical isolation layer is silicon nitride.

10. The method of any one of the preceding claims wherein said gate dielectric (2) is a thin silicon dioxide layer.

11. The method of any one of the preceding claims wherein said gate electrode (3) is doped polysilicon.

12. A semiconductor device which comprises a semiconductor substrate (1) having channel regions containing active impurities of a first conductive type; a gate dielectric layer (2) over said channel region; gate electrodes (3) over said dielectric; doped regions (4, 5) of a second and opposite conductive type self-aligned with respect to opposite ends of said gate electrodes (3); isolation trenches (6) containing isolation material (7) to isolate individual FETs on the same substrate; isolation (8) on the sides of said gate electrodes; and wherein said gate electrodes are self-aligned with respect to said isolation trenches such that they are butted against said isolation trenches; insulating layer (13) over the entire substrate (1) for vertical isolation through which contact windows are provided to said gate electrodes (3) and said doped regions (4, 5) and metallic type high conductivity electrical interconnection (14) to said gate electrodes (3) and to said source and drain regions (4, 5).

13. The semiconductor device of claim 12 wherein the material of said layer (13) which provides vertical isolation exhibits different etching characteristics with respect to the material (7) in said trenches and the material (8) on the sides of said gate electrodes.

14. The semiconductor device of claim 12 or 13, wherein the material (13) of said layer which provides vertical isolation is silicon nitride and the material (7, 8) in said trenches and on the sides of said gate electrodes is silicon dioxide.

15. The semiconductor device of claim 12, 13 or 14, wherein the gate contact window is designed to overlap the insulating material (8) on the side-walls of the said gate electrodes (3) by a distance either equal to, or greater than, the maximum permitted lithographic misregistration of the contact windows with respect to the gate electrodes.

16. The semiconductor device of any one of the preceding claims 12 - 15, which further includes silicide regions (12) located between said metallic-type high conductivity electrical connections (14) and said gate electrodes (3) and doped regions.

17. The semiconductor device of any one of the preceding claims 12 - 16, having active area with dimensions of about 0.7 by 0.15 microns being separated from adjacent devices by about 0.15 microns width isolation trench.

**FIG. 1** PRIOR ART

GATE
ELECTRODE

PARASITIC
CHANNELS

ADDITIONAL
ELECTRIC FIELD

**FIG. 2** PRIOR ART

GATE
ELECTRODE

**FIG. 3**

*FIG. 4*

*FIG. 5*

*FIG. 6*

*FIG. 7*

FIG. 8

FIG. 9

FIG. 10

FIG. 11